(19) **Europäisches Patentamt**
**European Patent Office**
**Office européen des brevets**

(11) Numéro de publication : **0 515 282 B1**

(12) # FASCICULE DE BREVET EUROPEEN

(45) Date de publication du fascicule du brevet :
**27.07.94 Bulletin 94/30**

(51) Int. Cl.⁵ : **H02H 9/04,** H01L 27/02

(21) Numéro de dépôt : **92401400.4**

(22) Date de dépôt : **21.05.92**

(54) **Structure de protection dans un circuit CMOS contre le verrouillage.**

(30) Priorité : **24.05.91 FR 9106285**

(43) Date de publication de la demande :
**25.11.92 Bulletin 92/48**

(45) Mention de la délivrance du brevet :
**27.07.94 Bulletin 94/30**

(84) Etats contractants désignés :
**DE FR GB IT**

(56) Documents cités :
**EP-A- 0 324 185**
**GB-A- 2 227 898**
**US-A- 4 939 616**
**PATENT ABSTRACTS OF JAPAN, vol. 11, no.**
**165 (E-510)(2612), 27 mai 1987 ; & JP-A-61 296**
**770**
**PATENT ABSTRACTS OF JAPAN, vol. 11, no.**
**265 (E-535)(2712), 27 août 1987 ; & JP-A-62 069**
**661**

(73) Titulaire : **SGS-THOMSON**
**MICROELECTRONICS S.A.**
**7, Avenue Galliéni**
**F-94250 Gentilly (FR)**

(72) Inventeur : **Tailliet, François**
**Cabinet Ballot-Schmit,**
**7, rue le Sueur**
**F-75116 Paris (FR)**

(74) Mandataire : **Schmit, Christian Norbert Marie**
**et al**
**Cabinet Ballot-Schmit**
**7, rue Le Sueur**
**F-75116 Paris (FR)**

**Description**

L'invention concerne les circuits intégrés CMOS et plus précisément leur protection contre le phénomène de verrouillage qui peut détruire certaines parties du circuit intégré CMOS.

La technologie CMOS génère de nombreuses structures à quatre couches PNPN qui, en formant des transistors bipolaires et des résistances latérales, sont en fait de réels thyristors.

Une impulsion parasite unique ou une surtension sur l'alimentation peuvent provoquer le déclenchement de certains de ces thyristors : c'est le phénomène de verrouillage (latch-up dans la littérature anglo-saxonne) des circuits CMOS.

Le déclenchement de ces structures établit un court-circuit plus ou moins franc, généralement destructif par suréchauffement du circuit. Pour éviter le verrouillage, on utilise de manière classique des règles de dessins des circuits CMOS très strictes. En particulier :

- pour réduire le gain des transistors bipolaires, on augmente la largeur de leur base : profondeur importante des caissons, diffusions dans le substrat éloignées des caissons,
- pour réduire les résistances latérales, on multiplie les prises de substrat et de caisson.

La réduction des résistances latérales, sert aussi à réduire le gain des transistors bipolaires (par court-circuit de la jonction émetteur-base).

Ces règles sont très contraignantes et coûteuses en place pour un résultat incertain en pratique : pour un circuit, elles vont donner de très bons résultats, pour un autre, de très mauvais.

On préfère utiliser dans certains cas, au lieu d'un substrat uniformément dopé dans la masse (substrat massif), un substrat épitaxié. Le substrat épitaxié est un substrat très fortement enrichi, par exemple $N^+$, surmonté d'une très fine couche épitaxiée peu dopée $N^-$. Il permet principalement de réduire les résistances latérales, mais c'est une technologie fort coûteuse pour un résultat qui reste non garanti (problème de reproductibilité du résultat d'un circuit à l'autre).

Soit un circuit CMOS. Il reçoit sur deux bornes d'alimentation, une tension positive Vcc, en général 5 volts en valeur nominale et une tension négative ou nulle Vss, en général 0 volts. Le circuit CMOS accepte une tension maximum Vmax = Vcc - Vss à ses bornes de l'ordre de 7 volts. L'immunité du circuit CMOS au verrouillage est définie par la surtension $V_1$ et le courant externe $I_1$ pour lesquels le verrouillage se déclenche. $V_1$ doit être supérieure à Vmax. Typiquement on cherche à avoir V1 supérieur à 2Vmax et le courant $I_1$ le plus élevé possible. Les solutions précédemment décrites permettent d'avoir $I_1$ de l'ordre de 20 milliampères. Dans l'invention, on cherche à porter $I_1$ jusqu'à la centaine de milliampères. Ainsi on aura des produits CMOS réellement bien protégés contre le verrouillage. De plus, on cherche à réduire le coût de la protection en place occupée dans le circuit et en prix de revient.

Dans l'invention, on part d'un circuit CMOS de technologie classique, avec des paramètres limites d'immunisation au verrouillage (V1, I1) propres à la circuiterie interne.

Dans l'invention, on intercale entre les bornes d'alimentation, en parallèle sur la circuiterie interne CMOS, un composant d'écrêtage qui se déclenche pour une tension E à ses bornes inférieure à V1 et qui consomme un fort courant $I_e$ bien supérieur au courant I1 pour une tension V1 à ses bornes, c'est à dire un composant avec une résistance équivalente faible quand il est déclenché.

Dans l'invention le composant d'écrêtage est intégré dans le circuit CMOS. Ainsi, si l'intensité du courant externe pour déclencher le verrouillage dans la circuiterie interne reste inchangée (I1), par contre le courant total externe I'1 à fournir au circuit CMOS, égal à I1 sans l'écrêteur, est augmenté dans l'invention du courant (Ie) transitant par l'écrêteur. On a ainsi augmenté la valeur apparente I'1 du courant externe de déclenchement du verrouillage. Cette valeur apparente dépend alors du dimensionnement de l'écrêteur.

Dans un perfectionnement, l'écrêteur est protégé des décharges électrostatiques.

L'invention concerne donc un circuit CMOS protégé contre un phénomène de verrouillage, comportant une circuiterie interne alimentée entre une première borne d'alimentation positive et une deuxième borne d'alimentation négative ou nulle, la circuiterie interne ayant comme paramètres connus un courant et une tension de déclenchement de verrouillage, caractérisé en ce qu'un écrêteur est placé en parallèle sur la circuiterie interne, entre la première et la deuxième borne d'alimentation, cet écrêteur ayant un seuil de déclenchement inférieur à la tension de déclenchement de verrouillage de la circuiterie interne et consommant un courant très supérieur au courant de déclenchement du verrouillage de la circuiterie interne quand une tension au moins égale à la tension de déclenchement de verrouillage est appliquée entre la première et deuxième borne d'alimentation.

D'autres caractéristiques et avantages de l'invention sont donnés dans la description qui suit faite à titre indicatif et non limitatif de l'invention et en référence aux dessins annexés dans lesquels :

FIG.1 est un schéma synoptique d'un circuit CMOS comportant un dispositif de protection contre le verrouillage selon l'invention,

FIG.2 représente une structure d'un dispositif connu de protection aux décharges électrostatiques,

FIG.3 est un schéma électrique d'un circuit CMOS dans un premier exemple de réalisation d'un écrêteur selon l'invention, utilisant le dispositif représenté sur FIG.2,

FIG.4 représente une structure d'un écrêteur dans un deuxième exemple de réalisation selon l'invention,

FIG.5 est un schéma électrique d'un circuit CMOS conformément à FIG.4.

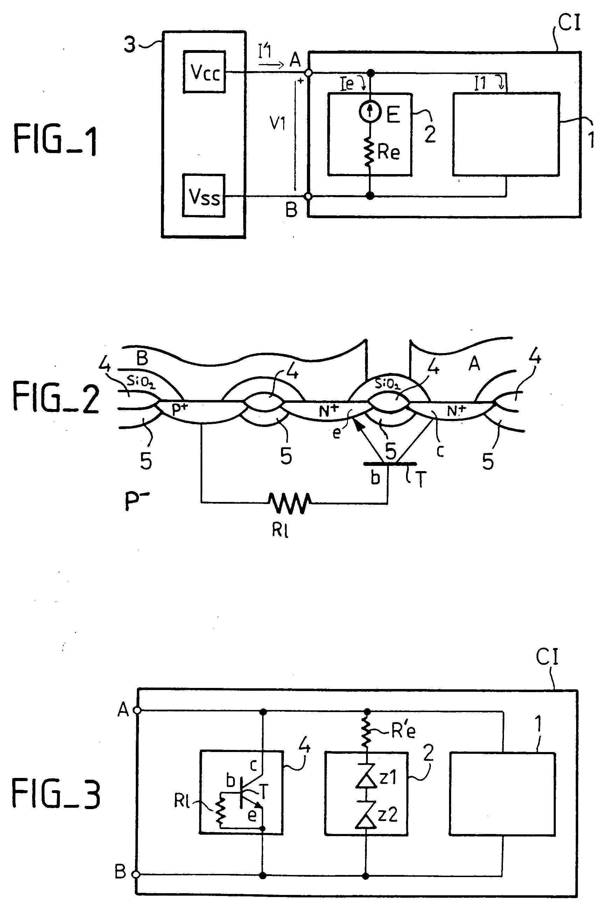

FIG.1 est un schéma synoptique d'un dispositif de protection selon l'invention. Un circuit intégré CMOS CI comporte une circuiterie interne 1 à protéger du verrouillage et un écrêteur 2. Chaque élément 1, 2 est monté en parallèle sur deux bornes d'alimentation A et B. Une alimentation 3 fournit une tension positive Vcc sur la borne A et une tension négative ou nulle Vss sur la borne B.

La différence de potentiel V entre les deux bornes d'alimentation du circuit CMOS CI a classiquement une valeur typique de 5 volts notée Vdd et une valeur maximum de l'ordre de 7 volts notée Vmax. Pour un seuil E de tension aux bornes du circuit CMOS, donc aux bornes de l'écrêteur, ce dernier se déclenche. Il se comporte alors comme un générateur de tension E de thévenin en série avec une résistance faible Re (FIG.1)

Ainsi, si la circuiterie interne 1 du circuit CMOS est caractérisée par un couple courant/tension de déclenchement du verrouillage noté (I1, V1), si la tension V aux bornes du circuit CMOS devient égale à V1 (surtension sur l'alimentation) et si le seuil E de déclenchement de l'écrêteur est inférieur à la tension $V_1$, alors l'intensité du courant $I_e$ qui transite dans l'écrêteur est donnée par l'expression suivante :

$$Ie = \frac{V1 - E}{Re}$$

L'écrêteur 2 et la circuiterie interne 1 étant chacun en parallèle sur les bornes A et B d'alimentation du circuit CMOS, en cas de surtension d'alimentation V1, il faut que l'alimentation externe fournisse un courant I'1 égal à la somme des courants des deux branches soit : I'1 = Ie + I1, pour déclencher le verrouillage.

Le courant de déclenchement du verrouillage de la circuiterie interne 1 est toujours I1, mais le courant apparent I'1 de déclenchement du verrouillage du circuit CMOS est lui augmenté du courant transitant dans l'écrêteur qui a la tension V1 à ses bornes.

On peut aisément obtenir des courants assez importants de l'ordre de la centaine de milliampères avec des réalisations d'écrêteurs bien connues, dont on va décrire deux exemples dans la suite.

Pour éviter une surconsommation du circuit CMOS, on choisira de préférence un écrêteur avec un seuil E supérieur à la tension maximale Vmax admissible par le circuit CMOS. Dans un exemple Vmax vaut 7 volts et E vaut 12 volts.

D'une manière générale l'écrêteur selon l'invention a un seuil E compris entre 10 et 15 volts (E>Vmax, E<V1), et une résistance dynamique Re faible (jusqu'à quelques dizaines d'ohms) de manière à laisser passer beaucoup de courant : on cherche un gain en courant de latch-up élevé.

Ainsi dans un exemple classique de circuit CMOS avec une tension de déclenchement du verrouillage V1 de l'ordre de 18 volts, et un courant de déclenchement du verrouillage I1 de l'ordre de 20 milliampères, on détermine aisément les caractéristiques nécessaires (E,Re) de l'écrêteur pour avoir un courant apparent de déclenchement I'1 par exemple de 20 milliampères pour une surtension $V_1$. On a en effet les relations suivantes :

Vmax<E<V1

I'1 = I1 + Ie et

$$Ie = \frac{(V1 - E)}{Re}$$

E est choisi par exemple égal à 12 volts, d'où dans cet exemple numérique,

Re = 20 ohms.

Le courant Ie, pour une surtension V1 de 18 volts, est égal dans cet exemple à 300 milliampères.

Pour éviter une surconsommation du circuit CMOS, on choisira de préférence un écrêteur avec un seuil E supérieur à la tension maximale Vmax admissible par le circuit CMOS. Dans l'exemple numérique précédent, E vaut 12 volts et Vmax vaut 7 volts.

D'une manière générale l'écrêteur a un seuil E compris entre 10 et 15 volts (E>Vmax, E<V1), et une résistance dynamique Re faible (jusqu'à quelques dizaines d'ohms) de manière à laisser passer beaucoup de courant : on cherche un gain en courant de latch-up élevé.

Dans un premier exemple de réalisation, illustré sur FIG.3, un écrêteur se compose de diodes zener en série et en inverse, telles que la somme des tensions de seuil des diodes soit égale à la tension de déclenchement E de l'écrêteur. Il est possible d'avoir une seule diode en inverse avec la tension de seuil voulue ou, d'une manière plus générale, une association série de composants assimilables en fonctionnement à des diodes en inverse (transistor monté en diode par exemple).

Dans un exemple préféré (FIG.3), on aura deux diodes zener en série, du type "CMOS", formées chacune d'une jonction $P^+/N^+$ (non représentée) dans un caisson, avec une tension de seuil typique de l'ordre de 6 volts. Un exemple de réalisation pratique de telles diodes est décrit dans le brevet italien n° 2 2228 A/89 déposé au nom de Sgs-Thomson Microelectronics s.r.l. le 31 octobre 1989.

Ce dispositif à diodes équivaut à un écrêteur unique assimilé à un générateur de Thévenin de caractéristiques E, Re de l'ordre de 12 volts et 20 Ohms. Mais il ne résiste pas intrinsèquement aux décharges électrostatiques, autre phénomène auquel sont très sensibles les circuits CMOS. En effet, les décharges électrostatiques peuvent induire des courants de plusieurs ampères. Il faut donc adjoindre à l'écrêteur, un dispositif de protection aux décharges électrostatiques. La circuiterie interne 1 CMOS est elle classiquement déjà protégée aux décharges électrostatiques.

De manière connue (FIG.2), le dispositif de protection aux décharges électrostatiques est un transistor bipolaire latéral T, par exemple de type NPN dans un substrat P⁻. On pourrait aussi utiliser un transistor latéral de type PNP réalisé dans un caisson N. Dans l'exemple, le transistor bipolaire latéral NPN est obtenu dans un substrat P⁻ avec de droite à gauche une première diffusion N⁺ c reliée à Vcc, une deuxième diffusion N⁺ e reliée à Vss et une troisième diffusion P⁺ de prise de substrat reliée à Vss : la diffusion c est le collecteur et la diffusion e l'émetteur du transistor bipolaire T de protection de type NPN dans cet exemple. Sa base b est constituée par la zone de substrat entre l'émetteur et le collecteur, et polarisée via une résistance latérale R1 entre le substrat P⁻ et la zone de diffusion P⁺. Les diffusions sont isolées entre elles par une couche d'oxyde de champ 4 et, sous chaque couche d'oxyde de champ, une zone 5 plus dopée que le substrat P⁻, zone 5 appelée en général zone P-iso ou encore "implantation de champ". Le seuil de déclenchement du transistor T est lié à la tension d'avalanche de sa jonction collecteur-base. Cette tension Vo est liée au dopage superficiel dans cette zone du substrat et plus précisément par la zone 5 P-iso entre les deux diffusions N⁺ e et c. Dans le cas de procédés CMOS actuels typiques, cette tension Vo est de l'ordre de 20 volts.

Or la tension E de déclenchement de l'écrêteur est de l'ordre de 12 volts et dans tous les cas, inférieure à 20 volts. Le seuil E est donc inférieur à celui du dispositif 4 de protection aux décharges électrostatiques et en, cas de décharges électrostatiques, seul l'écrêteur va alors conduire. Ce dispositif 4 de protection décrit sur FIG.2 ne sert donc à rien et l'écrêteur risque d'être détruit.

Aussi, on intercale en série une résistance de protection R'e entre la borne A (Vcc) et l'écrêteur (FIG.3). Entre 12 et 20 volts, cette résistance R'e permet à la tension aux bornes du dispositif 4 de protection d'atteindre au moins 20 volts, ce qui permet de le déclencher et donc de limiter le courant de décharge I'e dans l'écrêteur.

On note Icrit le courant maximal admissible dans l'écrêteur. En pratique, il faut que le courant I'e traversant l'écrêteur soit inférieur à Icrit soit : I'e < Icrit. Icrit, Vo, E, Re étant connus et I'e dans la FIG.3 s'exprimant par :

$$I'e = \frac{Vo - E}{Re + R'e}$$

I'e < Icrit entraîne :

$$R'e > \frac{(Vo - E)}{Icrit} - Re$$

On cherche de plus à avoir un gain maximum en courant dans l'écrêteur pour la protection contre le latchup : il faut donc choisir R'e le plus faible possible. On pourra se rapprocher en pratique de la valeur minimale Rmin donnée dans l'inégalité précédente soit :

$$Rmin = \frac{Vo - E}{Icrit} - Re$$

De préférence, pour plus de sécurité, on choisira plutôt que le courant maximal transitant dans l'écrêteur soit Icrit/2 et donc on choisira :

$$(1) \qquad R'e = \frac{2(Vo - E)}{Icrit} - Re$$

Le courant passant dans l'écrêteur en cas de surtension V1 (appliquée entre les bornes A et B) est alors :

$$(2) \qquad I'e = \frac{(V1 - E)}{Re + R'e}$$

Dans un exemple numérique, avec Icrit = 400 mA Vo = 20 volts, Re = 20 Ohms, V1 = 18 volts et E = 12 volts,
de (1) il vient : R'e = 20 Ohms
et de (2) il vient : I'e = 150 mA.

Le courant apparent de déclenchement du verrouillage du circuit CMOS est donc :

I'1 = I1 + I'e = 20 + 150 = 170 mA

Ainsi, le gain en courant est moindre que sans protection aux décharges électrostatiques (on passe de I'1=300 mA à I'1=170 mA), mais il reste de niveau très satisfaisant.

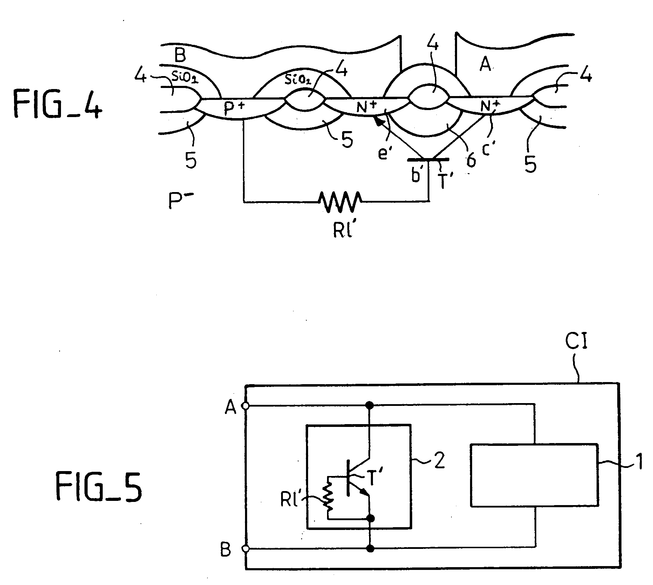

Dans un autre exemple de réalisation de l'écrêteur (FIG. 4), on utilise un transistor bipolaire latéral T' comme celui vu précédemment pour le dispositif de protection aux décharges électrostatiques (FIG.2), mais en surdopant sa base b' c'est-à-dire en surdopant la zone 6 P-iso (FIG.4) entre les deux diffusions N⁺ qui forment l'émetteur e' et le collecteur c'. On a vu en effet que ce faisant, on ajustait le seuil Vo de déclenchement de ce dispositif classique de protection aux décharges électrostatiques (par modification de la tension d'avalanche collecteur-base). Ainsi on peut régler le seuil Vo de déclenchement du transistor T' entre 10 et 15 volts, par exemple à 12 volts. Dans un tel dispositif, quand il est déclenché, la résistance dynamique est quasiment nulle : il absorbe donc tout le courant, sans limite. Il devient donc impossible de déclencher le verrouillage (latch-up) : on a un écrêteur (FIG.5) de caractéristiques E = 12 volts et Re = 0 ohm.

Le dispositif de protection aux décharges électrostatiques est donc devenu, en abaissant son seuil de déclenchement, également un dispositif de protection contre le verrouillage. Mais, ce dispositif est plus coûteux que dans le premier exemple de réalisation, car il nécessite un niveau de masquage/implantation supplémentaire dans la fabrication du circuit CMOS, pour surdoper la base (réalisation de la zone 6). Par contre son efficacité est totale, car il interdit radicalement le verrouillage et car il est protégé intrinsèquement des décharges électrostatiques.

D'autres réalisations d'écrêteurs avec les conditions requises (E entre 10 et 15 volts environ, Re faible) sont bien sûr possibles pour protéger du verrouillage selon l'invention.

## Revendications

1. Circuit CMOS protégé contre un phénomène de verrouillage, comportant une circuiterie interne (1) alimentée entre une première borne (A) d'alimentation positive (Vcc) et une deuxième borne (B) d'alimentation négative ou nulle (Vss), la circuiterie interne (1) ayant comme paramètres connus un courant (I1) et une tension (V1) de déclenchement de verrouillage, caractérisé en ce qu'un écrêteur (2) est placé en parallèle sur la circuiterie interne (1), entre la première (A) et la deuxième borne (B) d'alimentation, cet écrêteur (2) ayant un seuil de déclenchement (E) inférieur à la tension de déclenchement de verrouillage (V1) de la circuiterie interne (1) et consommant un courant (Ie) très supérieur au courant de déclenchement du verrouillage (I1) de la circuiterie interne (1) quand une tension au moins égale à la tension de déclenchement de verrouillage (V1) est appliquée entre la première et la deuxième borne d'alimentation.

2. Circuit CMOS selon la revendication 1, caractérisé en ce que le seuil de déclenchement (E) de l'écrêteur est supérieur à une tension maximale (Vmax) autorisée pour le fonctionnement de la circuiterie interne CMOS.

3. Circuit CMOS selon la revendication 2, caractérisé en ce que l'écrêteur se compose de diodes zener montées en série et en inverse entre la première (A) et la deuxième borne (B) d'alimentation, la somme des tensions de seuil des diodes étant égal au seuil de déclenchement de l'écrêteur ainsi constitué.

4. Circuit CMOS selon la revendication 3, caractérisé en ce que l'écrêteur se compose de deux diodes zener (z1, z2), chaque diode ayant un seuil de l'ordre de 6 volts.

5. Circuit CMOS selon la revendication 3, ou la revendication 4, caractérisé en ce qu'il comprend en parallèle sur l'écrêteur entre la première (A) et la deuxième borne (B) d'alimentation, un dispositif de protection (4) aux décharges électrostatiques.

6. Circuit CMOS selon la revendication 5, caractérisé en ce qu'une résistance de protection (R'e) de l'écrêteur est placée en série entre la première borne (A) d'alimentation et l'écrêteur (2).

7. Circuit CMOS selon la revendication 6, caractérisé en ce que le dispositif (4) de protection aux décharges électrostatiques, est un transistor bipolaire latéral (T) dont un collecteur (c) est connecté à la première borne (A) d'alimentation, un émetteur (e) et une base (b) sont connectés à la deuxième borne (B) d'alimentation.

8. Circuit CMOS selon la revendication 1 ou la revendication 2 caractérisé en ce que l'écrêteur (2) est un transistor bipolaire latéral (T') dont un collecteur (c') est connecté à la première borne (A) d'alimentation, dont un émetteur (e') et une base (b') sont connectés à la deuxième borne (B) d'alimentation et dont la base (b') a été surdopée pour diminuer une tension d'avalanche collecteur-base.

## Patentansprüche

1. CMOS-Schaltkreis, der gegen einen Verriegelungsfehler geschützt ist, und der aufweist eine innere Schaltung (1), die geschaltet ist zwischen einem ersten Anschluß (A) einer positiven Versorgungsquelle (Vcc) und einem zweiten Anschluß (B) einer negativen oder an Masse liegenden Versorgungsquelle (Vss), wobei die innere Schaltung (1) als bekannte Parameter einen Strom (I1) und eine Spannung (V1) zur Auslösung der Verriegelung aufweist, dadurch gekennzeichnet, daß ein Begrenzer (2) parallel zur inneren Schaltung (1) zwischen dem ersten Versorgungsanschluß (A) und dem zweiten Versorgungsanschluß (B) angeordnet ist, wobei der Begrenzer (2) eine Auslöseschwelle (E) aufweist, die kleiner ist als die Auslösespannung der Verriegelung (V1) der inneren Schaltung (1) und einen Strom (Ie) verbraucht, der sehr viel größer ist als der Auslösestrom der Verriegelung (I1) der inneren Schaltung (1), wenn eine Spannung zwischen dem ersten und dem zweiten Versorgungsanschluß angelegt wird, die wenigstens gleich der Auslösespannung der Verriegelung (V1) ist.

2. CMOS-Schaltkreis nach Anspruch 1, dadurch gekennzeichnet, daß die Auslöseschwelle (E) des Begrenzers größer ist als eine Maximalspannung (Vmax), welche die Wirkungsweise der inneren CMOS-Schaltung ermöglicht.

3. CMOS-Schaltkreis nach Anspruch 2, dadurch gekennzeichnet, daß der Begrenzer aus mehreren Zener-Dioden besteht, die in Reihe und invers zwischen dem ersten Versorgungsanschluß (A) und dem zweiten Versorgungsanschluß (B) geschaltet sind, wobei die Summe der Schwellwertspannungen dieser Dioden gleich der Auslöseschwelle des derart gebildeten Begrenzers ist.

4. CMOS-Schalkreis nach Anspruch 3, dadurch gekennzeichnet, daß der Begrenzer aus zwei Zener-Dioden (z1, z2) besteht, wobei jede Diode eine Schwelle in der Größenordnung von 6 Volt besitzt.

5. CMOS-Schaltkreis nach Anspruch 3 oder nach Anspruch 4, dadurch gekennzeichnet, daß er parallel zum Begrenzer zwischen dem ersten Versorgungsanschluß (A) und dem zweiten Versorgungsanschluß (B) eine Schutzvorrichtung (4) gegen elektrostatische Entladungen aufweist.

6. CMOS-Schaltkreis nach Anspruch 5, dadurch gekennzeichnet, daß ein Schutzwiderstand (R'e) des Begrenzers in Serie zwischen dem ersten Versorgungsanschluß (A) und dem Begrenzer (2) angeordnet ist.

7. CMOS-Schaltkreis nach Anspruch 6, dadurch gekennzeichnet, daß die Schutzvorrichtung (4) gegen elektrostatische Entladungen ein bipolarer Lateraltransistor (T) ist, dessen einer Kollektor (c) mit dem ersten Versorgungsanschluß (A) verbunden ist, während ein Emitter (e) und eine Basis (b) mit dem zweiten Versorgungsanschluß (B) verbunden sind.

8. CMOS-Schaltkreis nach Anspruch 1 oder Anspruch 2, dadurch gekennzeichnet, daß der Begrenzer (2) ein bipolarer Lateraltransistor (T') ist, dessen einer Kollektor (c') mit dem ersten Versorgungsanschluß (A) verbunden ist, während ein Emitter (e') und eine Basis (b') mit dem zweiten Versorgungsanschluß (B) verbunden sind und wobei die Basis (b') überdotiert worden ist um eine Kollektor-Basis-Durchbruchsspannung zu verringern.

**Claims**

1. CMOS circuit protected against a latch-up phenomenon, including internal circuitry (1) powered between a first terminal (A) for the positive power supply (Vcc) and a second terminal (B) for the negative or zero power supply (Vss), the internal circuitry (1) having as known parameters a latch-up trigger current (I1) and voltage (V1), characterised in that a clipping circuit (2) is mounted in parallel with the internal circuitry (1), between the first (A) and second (B) power supply terminals, this clipping circuit (2) having a trigger threshold (E) lower than the latch-up trigger voltage (V1) of the internal circuitry (1) and consuming a current (Ie) very much higher than the latch-up trigger current (I1) of the internal circuitry (1) when a voltage at least equal to the latch-up trigger voltage (V1) is applied between the first and second power supply terminals.

2. CMOS circuit according to Claim 1, characterised in that the trigger threshold (E) of the clipping circuit is higher than a maximum voltage (Vmax) allowed for the functioning of the CMOS internal circuitry.

3. CMOS circuit according to Claim 2, characterised in that the clipping circuit consists of Zener diodes mounted in series and in reverse between the first (A) and second (B) power supply terminals, the sum of the threshold voltages of the diodes being equal to the trigger threshold of the clipping circuit thus formed.

4. CMOS circuit according to Claim 3, characterised in that the clipping circuit consists of two Zener diodes (z1, z2), each diode having a threshold of around 6 volts.

5. CMOS circuit according to Claim 3 or Claim 4, characterised in that it comprises, in parallel with the clipping circuit between the first (A) and second (B) power supply terminals, a device (4) for protection against electrostatic discharges.

6. CMOS circuit according to Claim 5, characterised in that a resistor (R'e) for protecting the clipping circuit is mounted in series between the first power supply terminal (A) and the clipping circuit (2).

7. CMOS circuit according to Claim 6, characterised in that the device (4) for protecting against electrostatic discharges is a lateral bipolar transistor (T), on which a collector (c) is connected to the first power supply terminal (A) and an emitter (e) and base (b) are connected to the second power supply terminal (B).

8. CMOS circuit according to Claim 1 or Claim 2, characterised in that the clipping circuit (2) is a lateral bipolar transistor (T'), on which a collector (c') is connected to the first power supply terminal (A) and an emitter (e') and base (b') are connected to the second power supply terminal (B), and on which the base (b') has been heavily doped in order to reduce a collector-base avalanche voltage.

FIG_1

FIG_2

FIG_3

FIG_4

FIG_5